# EUROPEAN PATENT SPECIFICATION

(11) **EP 4 038 395 B1**
(45) Date of publication and mention of the grant of the patent: **28.10.2026**
(21) Application number: 20872096.1
(22) Date of filing: 23.09.2020
(51) Int. Cl.: G01Q 40/00, G01R 35/00, G01R 31/00

(54) **SYSTEMS AND METHODS FOR CHARACTERIZING OPTICAL COUPLING BETWEEN AN OPTICAL PROBE AND A CALIBRATION STRUCTURE**
SYSTEME UND VERFAHREN ZUR CHARAKTERISIERUNG DER OPTISCHEN KOPPLUNG ZWISCHEN EINER OPTISCHEN SONDE UND EINER KALIBRIERUNGSSTRUKTUR
SYSTÈMES ET PROCÉDÉS DE CARACTÉRISATION DE COUPLAGE OPTIQUE ENTRE UNE SONDE OPTIQUE ET UNE STRUCTURE D'ÉTALONNAGE

(30) Priority: 30.09.2019 US 201962908423 P; 30.09.2019 US 201962908403 P; 30.09.2019 US 201962908440 P; 22.11.2019 US 201962939399 P; 22.09.2020 US 202017028102
(43) Date of publication of application: 10.08.2022
(60) Divisional application: 26206279.7
(73) Proprietor: FormFactor, Inc., Livermore, California 94551 (US)
(72) Inventor: FRANKEL, Joseph George, Beaverton, Oregon 97006 (US); NEGISHI, Kazuki, Hillsboro, Oregon 97006 (US)
(74) Representative: Willett, Christopher David
(86) International application number: PCT/US2020/052127
(87) International publication number: WO 2021/067084

(56) References cited:
- US-A- 5 412 330
- US-A1- 2006 109 015
- US-A1- 2014 149 811
- US-A1- 2014 203 830
- US-A1- 2014 268 167
- US-A1- 2016 239 720
- US-A1- 2018 010 906
- US-B1- 6 608 494
- US-B1- 7 129 722

## Description

### Field of the Disclosure

The present disclosure relates generally to probe systems and methods for characterizing optical coupling between an optical probe of a probe system and a calibration structure.

### Background of the Disclosure

Probe systems may be utilized to probe and/or to test the operation of a device under test (DUT). Optical probe systems have been developed to probe optical DUTs that include optical components. Optical probe systems utilize optical probes to provide signals, such as photonic signals, electromagnetic signals, and/or photons, to an optical device of the optical DUT and/or receive the signals from the optical device. In general, the optical probe and the optical device are positioned in a spaced-apart relationship, with a gap, or an air gap, of a few micrometers separating the optical probe and the optical device. Optical coupling, or an efficiency of the optical coupling, between the optical probe and the optical device can vary by orders of magnitude based upon a variety of factors, including a relative orientation, or alignment, between the optical probe and the DUT, optical characteristics of the optical probe itself, and/or optical characteristics of the DUT. It may be desirable to quantify this variation, such as to permit and/or facilitate more accurate determination of the optical properties of the optical device. Thus, there exists a need for improved methods of characterizing optical coupling between an optical probe of a probe system and an optical device and/or for probe systems that perform the methods.

US 2018/010906 A1 and US 2014/149811 A1 disclose probe systems and methods for characterizing optical coupling between an optical probe of a probe system and a calibration structure.

### Summary of the Disclosure

The invention is defined by a probe system according to claim 1, a method of characterizing optical coupling between an optical probe of a probe system and a calibration structure according to claim 9 and an associated non-transitory computer-readable storage media according to claim 13. Further aspects are defined by the corresponding dependent claims.

Probe systems and methods of characterizing optical coupling between an optical probe of a probe system and a calibration structure. The probe systems include a probe assembly that includes an optical probe, a support surface configured to support a substrate that includes a device under test (DUT), and a signal generation and analysis assembly configured to generate an optical signal and to provide the optical signal to the optical device via the optical probe. The probe systems also include an electrically actuated positioning assembly configured to selectively adjust a relative orientation between the optical probe and the DUT, a calibration structure configured to receive the optical signal, and an optical detector configured to detect a signal intensity of the optical signal.

The probe systems further include a controller programmed to control the operation of the probe system by positioning the optical probe and the calibration structure proximate one another and conveying the optical signal from the optical probe to the calibration structure. During the conveying, the controller also is programmed to control the operation of the probe system by detecting the signal intensity of the optical signal. During the conveying and also during the detecting, the controller further is programmed to control the operation of the probe system by changing the relative orientation between the optical probe and the calibration structure to generate a representation of signal intensity as a function of the relative orientation between the optical probe and the calibration structure.

The methods include positioning the optical probe and the calibration structure proximate one another and conveying an optical signal from the optical probe to the calibration structure. During the conveying, the methods also include detecting a signal intensity of the optical signal. During the conveying and also during the detecting, the methods further include changing a relative orientation between the optical probe and the calibration structure to generate a representation of the signal intensity as a function of the relative orientation between the optical probe and the calibration structure.

### Brief Description of the Drawings

Fig. 1 is a schematic illustration of examples of probe systems that may be utilized to perform methods according to the present disclosure.
Fig. 2 is a less schematic illustration of examples of a region of the probe system of Fig. 1.
Fig. 3 is a less schematic illustration of examples of a region of the probe system of Fig. 1.
Fig. 4 is a less schematic illustration of examples of a region of the probe system of Fig. 1.
Fig. 5 is a flowchart depicting examples of methods of characterizing optical coupling between an optical probe of a probe system and a calibration structure according to the present disclosure.
Fig. 6 is an example of a representation of signal intensity as a function of the relative orientation between an optical probe and a calibration structure, according to the present disclosure.
Fig. 7 is an example of a representation of signal intensity as a function of the relative orientation between an optical probe and a calibration structure, according to the present disclosure.

### Detailed Description and Best Mode of the Disclosure

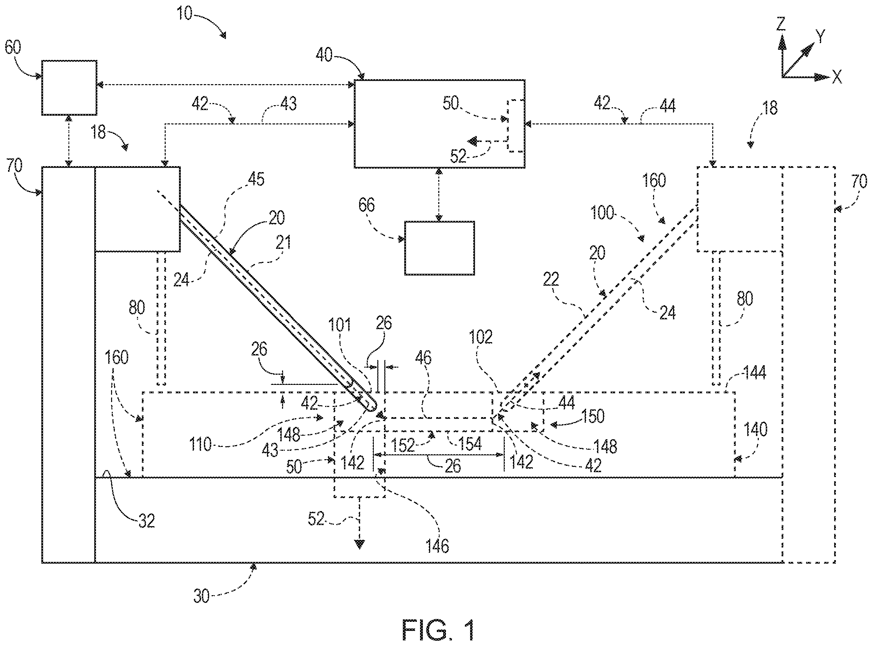

Figs. 1-7 provide examples of probe systems 10 and/or of methods 200, according to the present disclosure. Elements that serve a similar, or at least substantially similar, purpose are labeled with like numbers in each of Figs. 1-7, and these elements may not be discussed in detail herein with reference to each of Figs. 1-7. Similarly, all elements may not be labeled in each of Figs. 1-7, but reference numerals associated therewith may be utilized herein for consistency. Elements, components, and/or features that are discussed herein with reference to one or more of Figs. 1-7 may be included in and/or utilized with any of Figs. 1-7 without departing from the scope of the present disclosure. In general, elements that are likely to be included in a particular embodiment are illustrated in solid lines, while elements that are optional are illustrated in dashed lines. However, elements that are shown in solid lines may not be essential and, in some embodiments, may be omitted without departing from the scope of the present disclosure.

Fig. 1 is a schematic illustration of examples of probe systems 10 that may be utilized to perform methods 200, according to the present disclosure. Probe systems 10 include a probe assembly 18 that includes an optical probe 20. Probe systems 10 also include a support surface 32 configured to support a substrate 140 that includes a device under test (DUT) 150. The DUT may include an optical device 152. Probe systems 10 further include a signal generation and analysis assembly 40 that may be configured to generate an optical signal 42, in the form of an input optical signal 43, and/or to provide input optical signal 43 to optical device 152 via optical probe 20. Probe systems 10 also include an electrically actuated positioning assembly 70, which may be configured to selectively adjust a relative orientation between optical probe 20 and DUT 150. Probe systems 10 further include an optical detector 50, which may be configured to detect a signal intensity of optical signal 42, such as of input optical signal 43 that is received by the optical device and/or of an output optical signal 44 that is emitted from the optical device. Probe systems 10 also include a controller 60, which may be programmed to control the operation of at least one component of the probe system.

In one configuration, Fig.1 illustrates probe systems 10 as utilized to test, or to optically test, the operation, or the optical operation, of optical device 152 of DUT 150. In such a configuration, optical probe 20 may be utilized to provide input optical signal 43 to the optical device of the DUT. The input optical signal may be transferred, or optically coupled, from the optical probe to optical device 152 of DUT 150 via and/or across a gap 26. Gap 26 also may be referred to herein as an air gap 26 and/or as a distance 26 that the input optical signal travels between the optical probe and the optical device of the DUT. As discussed, a coupling efficiency between the optical probe and the optical device of the DUT, via gap 26, may depend upon a variety of factors, including a relative orientation between the optical probe and the optical device of the DUT, one or more optical characteristics of the optical probe, one or more optical characteristics of the optical device, and/or one or more optical characteristics of a coupling structure, such as a grating coupler and/or a waveguide of the optical device.

It may be beneficial and/or desirable to maximize, optimize, and/or increase this coupling efficiency, to decrease the impact of variations in this coupling efficiency on a measured performance of the optical device of the DUT, and/or to quantify this coupling efficiency as a function of the relative orientation between the optical probe and the DUT. Additionally or alternatively, it may be beneficial and/or desirable to quantify the impact of coupling efficiency, or of variations in this coupling efficiency, on the measured performance of the optical device of the DUT. This may be accomplished by improved characterization of the optical coupling, such as via utilizing probe systems 10 and/or methods 200 disclosed herein.

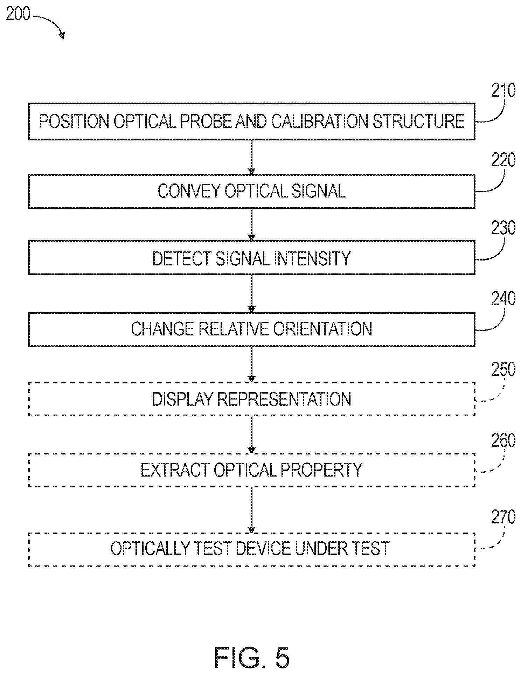

As discussed in more detail herein with reference to Fig. 5, Fig. 1 also schematically illustrates probe systems 10 as being utilized to characterize optical performance of optical probe 20, such as to improve and/or facilitate improved optical testing of the DUT. In such a configuration, substrate 140 may include a calibration structure 160 and/or the calibration structure may be utilized in place of the substrate. Additionally or alternatively, and in some examples, DUT 150 may include calibration structure 160 and/or calibration structure 160 may be defined by the DUT. Calibration structure 160 also may be referred to herein as and/or may be an optical calibration structure 160, an optical structure 160, and/or an optically active structure 160.

In some such examples, the optical probe may include and/or be a first optical probe, and probe system 10 may include a second optical probe 22, which may function as, may form a portion of, and/or may be the calibration structure. In such a configuration, second optical probe 22 also may be referred to herein as a device optical fiber 100, and gap 26 may, in some examples, be measured between the first optical probe and the second optical probe. In another example, calibration structure 160 may be positioned on, and/or may define, support surface 32.

In some examples, the calibration structure may be configured to convey at least a portion of the input optical signal between a first optical probe 21 and second optical probe 22. In some such examples, and as illustrated in Figs. 1-2, calibration structure 160 may include a first grating coupler 101, a second grating coupler 102, and a waveguide 154 that extends between the first grating coupler and the second grating coupler. In some such examples, the first probe and the second probe may be positioned above an upper surface 144 of calibration structure 160, and the first optical probe may be configured to provide input optical signal 43 to first grating coupler 101 along a signal axis 45, which also may be referred to herein as an incident axis 45, that defines an angle of incidence with the first grating coupler. The first grating coupler may receive at least a coupled portion of the input optical signal and may provide the coupled portion of the input optical signal to waveguide 154. The waveguide may provide the coupled portion of the input optical signal to second grating coupler 102, which then may provide output optical signal 44 to second optical probe 22. Optical detector 50 then may quantify the output optical signal.

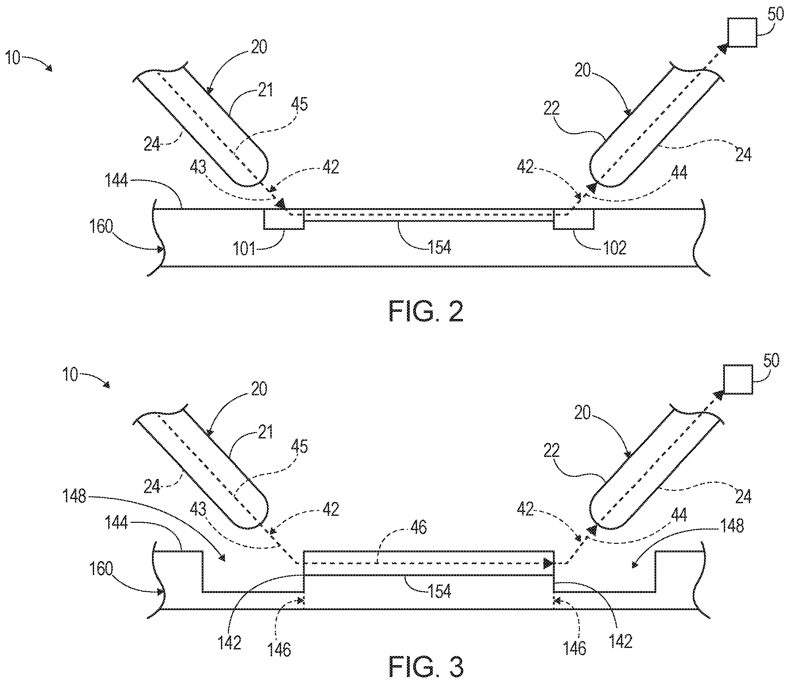

In some such examples, and as illustrated in Figs. 1 and 3, calibration structure 160 may define a vertical surface 142, such as a vertical surface of a trench 148 that may be defined within the substrate and/or of an edge 146 of the substrate. In these examples, first optical probe 21 may be positioned along the vertical surface and/or may provide input optical signal 43 to waveguide 154 such that the coupled portion of the input optical signal propagates within the waveguide along a waveguide signal axis 46. The waveguide then may convey the coupled portion of the optical signal to second optical probe 22, which may convey output optical signal 44 to optical detector 50. Optical detector 50 then may quantify the output optical signal.

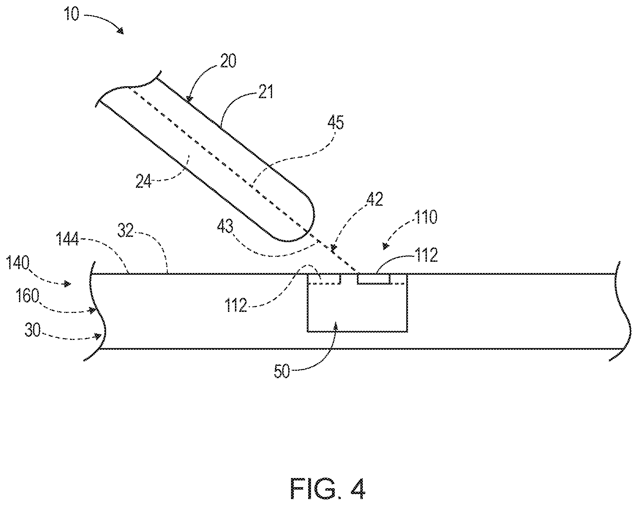

In some examples, and as illustrated in Figs. 1 and 4, optical detector 50 may define, or may be positioned within, calibration structure 160, support surface 32, and/or a chuck 30 that defines support surface 32. In some such examples, and as perhaps best illustrated in Fig. 4, calibration structure 160 may include and/or be an obstructive calibration structure 110. The obstructive calibration structure may include an optical obstruction 112 and may be configured to selectively obstruct an obstructed portion of input optical signal 43 such that the obstructed portion of the input optical signal is not incident upon the optical detector and thus to permit and/or facilitate characterization of the input optical signal. Examples of the obstructive calibration structure are discussed in more detail herein and include an optically reflective region, an optically absorptive region, a knife-edge calibration structure, and/or a pinhole calibration structure.

Regardless of the exact configuration, and as discussed in more detail herein, probe system 10 may be configured to convey a suitable optical signal 42, such as input optical signal 43 and/or output optical signal 44, from the optical probe to the calibration structure and to detect an intensity of the optical signal received by the calibration structure. Probe system 10 also may be configured to change a relative orientation between the optical probe and the calibration structure to generate a representation of signal intensity as a function of the relative orientation between the optical probe and the calibration structure, which also may be referred to herein as a "three-dimensional representation."

Stated another way, probe system 10 may be configured to and/or methods 200 may be utilized to characterize optical coupling between optical probe 20 and calibration structure 160, such as between the optical probe and a grating coupler and/or a waveguide of the calibration structure. This optical coupling may include a convolution of effects, some of which may be due to and/or caused by one or more optical characteristics of the optical probe and some of which may be due to and/or caused by one or more optical characteristics of the calibration structure. In some examples, probe system 10 and/or methods 200 may be utilized to deconvolute these effects, thereby permitting an operator of the probe system to more fully understand and/or characterize a given optical probe and/or a given calibration structure. In some examples, probe systems 10 and/or methods 200 may be utilized to detect and/or to determine an improved, desired, and/or optimal relative orientation between the optical probe and the calibration structure, such as to permit and/or to facilitate improved, higher-sensitivity, and/or lower-noise testing of an optical device by the probe system.

Probe assembly 18 may include any suitable structure that may include optical probes 20, including first optical probe 21 and/or second optical probe 22. As an example, probe assembly 18 and/or optical probe 20 thereof may include and/or be a fiber optic cable 24. Examples of fiber optic cable 24 include a cleaved fiber optic cable, a lensed fiber optic cable, a 3-D printed fiber assembly, and/or a faceted fiber optic cable. Optical probe 20 may be configured to convey optical signals 42, examples of which include infrared (IR) optical signals and/or visible spectrum optical signals.

Support surface 32 may include any suitable surface that may be adapted, configured, designed, sized, and/or constructed to support, or to operatively support, substrate 140. As an example, probe system 10 may include chuck 30 that may form and/or define support surface 32. Examples of chuck 30 include a wafer chuck, a calibration chuck, a vacuum chuck, and/or a temperature-controlled chuck. As another example, support surface 32 may be formed and/or defined by calibration structure 160.

Signal generation and analysis assembly 40 may include any suitable structure that may be adapted, configured, designed, and/or constructed to generate optical signal 42, such as in the form of input optical signal 43, and/or to provide the input optical signal to optical probe 20. In some examples, signal generation and analysis assembly 40 also may be configured to receive at least a portion of output signal 44 from substrate 140 and/or from calibration structure 160. In such a configuration, the signal generation and analysis assembly may include optical detector 50.

Signal generation and analysis assembly 40 additionally or alternatively may be configured to generate an electronic test signal, such as may be provided to DUT 150 via a corresponding electrical probe 80, and/or to receive an electronic resultant signal, such as may be received from DUT 150 via a corresponding electrical probe 80. Signal generation and analysis assembly 40 additionally or alternatively may be adapted, configured, designed, and/or constructed to analyze the operation and/or performance of DUT 150, such as may be based upon the input optical signal, the output optical signal, the electronic test signal, and/or the electronic resultant signal. Examples of signal generation and analysis assembly 40 include an optical signal generator, a laser, an optical signal detector, an electric signal generator, and/or an electric signal analyzer.

Electrically actuated positioning assembly 70 may include any suitable structure that may be adapted, configured, designed, and/or constructed to selectively adjust the relative orientation between optical probe 20 and substrate 140, DUT 150, and/or calibration structure 160. This may include selective and/or operative adjustment of the absolute position of the optical probe relative to the substrate, of the optical probe relative to the DUT, of the optical probe relative to the calibration structure, of the substrate relative to the optical probe, of the DUT relative to the optical probe, and/or of the calibration structure relative to the optical probe. Examples of electrically actuated positioning assembly 70 include a piezoelectric positioning assembly, a motorized positioning assembly, and/or a stepper motor.

Optical detector 50 may include any suitable structure that may be adapted, configured, designed, and/or constructed to detect the signal intensity of input optical signal 43 and/or output optical signal 44 as received by, emitted from, and/or coupled to the substrate, the DUT, an optical device of the DUT, and/or the calibration structure. In some examples, optical detector 50 may be configured to produce and/or to generate a signal intensity output, which also may be referred to herein as an electrical signal intensity output, 52. Probe system 10 may provide the signal intensity output to controller 60 and/or to signal generation and analysis assembly 40. Examples of optical detector 50 include an optical power meter, a photo detector, and/or a photo diode.

In some examples, optical detector 50 may be associated with, may form a portion of, and/or may be incorporated within signal generation and analysis assembly 40. In some such examples, optical detector 50 may be configured to detect and/or to quantify output optical signal 44 after the output optical signal has been emitted from the DUT, such as after the input optical signal has been coupled to, or conveyed through, the substrate, the DUT, the optical device, and/or the calibration structure to generate the output optical signal. Stated another way, and in some such examples, optical detector 50 may be configured to detect output optical signal 44 as conveyed from substrate 140 and/or calibration structure 160 by second optical probe 22.

In some examples, optical detector 50 may be associated with, may form a portion of, and/or may be incorporated within substrate 140, calibration structure 160, and/or chuck 30. In some such examples, optical detector 50 may be configured to detect and/or to quantify input optical signal 43 prior to the input optical signal being coupled to, or conveyed through, the substrate, the DUT, the optical device, and/or the calibration structure. Stated another way, and in some such examples, optical detector 50 may be configured to detect input optical signal 43 as conveyed toward and/or to substrate 140 and/or calibration structure 160 via first optical probe 21.

Calibration structure 160 may include any suitable structure that may, or that may be utilized to, convey input optical signal 43 from optical probe 20, or from first optical probe 21, to a corresponding optical detector 50, that may be configured to generate output optical signal 44, and/or that may be configured to move relative to the optical probe. Examples of calibration structure 160 are disclosed herein. Additional examples of calibration structure 160 include a calibration chuck, examples of which are disclosed in U.S. Patent Application No. 16/884,921, the complete disclosure of which is hereby incorporated by reference.

Controller 60 may include and/or be any suitable structure, device, and/or devices that may be adapted, configured, designed, constructed, and/or programmed to perform one or more of the functions disclosed herein. This may include control of the operation of any suitable portion, region, and/or structure of probe system 10, such as electrically actuated positioning assembly 70. This additionally or alternatively may include control according to any suitable step and/or steps of methods 200. As examples, controller 60 may include one or more of an electronic controller, a dedicated controller, a special-purpose controller, a personal computer, a special-purpose computer, a display device, a logic device, a memory device, and/or a memory device having computer-readable storage media.

The computer-readable storage media, when present, also may be referred to herein as non-transitory computer readable storage media. This non-transitory computer readable storage media may include, define, house, and/or store computer-executable instructions, programs, and/or code; and these computer-executable instructions may direct probe system 10 and/or controller 60 thereof to perform any suitable portion, or subset, of methods 200. Examples of such non-transitory computer-readable storage media include CD-ROMs, disks, hard drives, flash memory, etc. As used herein, storage, or memory, devices and/or media having computer-executable instructions, as well as computer-implemented methods and other methods according to the present disclosure, are considered to be within the scope of subject matter deemed patentable in accordance with Section 101 of Title 35 of the United States Code.

As illustrated in dashed lines in Fig. 1, and in some examples, probe systems 10 may include a display 66. Display 66, when present, may be configured to display, or to visibly display, an image, a representation, a multi-dimensional representation, a two-dimensional representation, and/or a three-dimensional representation of signal intensity as a function of the relative orientation between the optical probe and the calibration structure, such as to an operator of the probe system. Examples of display 66 include a monitor, a computer monitor, a television screen, and/or a flat panel display.

Substrate 140, when present, may include and/or be any suitable structure and/or structures. As an example, and as discussed, substrate 140 may include and/or be calibration structure 160, examples of which are disclosed herein. As additional examples, substrate 140 may include and/or be a wafer, a semiconductor wafer, a silicon wafer, a Group III-V semiconductor wafer, and/or an optical device wafer, and/or an optoelectronic device wafer. Device under test 150, when present, may include and/or be any suitable optical device and/or optoelectronic device.

Fig. 5 is a flowchart depicting examples of methods 200 of characterizing optical coupling between an optical probe of a probe system and a calibration structure, according to the present disclosure. Methods 200 include positioning an optical probe and an optical device at 210, conveying an optical signal at 220, and detecting a signal intensity at 230. Methods 200 also include changing a relative orientation at 240 and may include displaying a representation at 250, extracting an optical property at 260, and/or optically testing a device under test at 270.

Positioning the optical probe and the optical device at 210 may include positioning the optical probe and the calibration structure relative to and/or proximate one another. This may include positioning such that a gap, or an air gap, spatially separates the optical probe and the calibration structure. The gap, a length of the gap, and/or a distance between the optical probe and the calibration structure may have any suitable value. As examples, the distance may be at least 0.1 micrometer, at least 0.25 micrometers, at least 0.5 micrometers, at least 0.75 micrometers, at least 1 micrometer, at least 2 micrometers, at least 3 micrometers, at least 4 micrometers, at least 5 micrometers, at least 7.5 micrometers, at least 10 micrometers, at least 15 micrometers, at least 20 micrometers, at least 25 micrometers, at least 30 micrometers, at least 40 micrometers, at most 100 micrometers, at most 75 micrometers, at most 50 micrometers, at most 25 micrometers, at most 20 micrometers, at most 15 micrometers, at most 10 micrometers, at most 8 micrometers, at most 6 micrometers, at most 4 micrometers, at most 2 micrometers, and/or at most 1 micrometer.

The positioning at 210 may be performed utilizing any suitable structure. As examples, the positioning at 210 may be performed, facilitated, and/or controlled by electrically actuated positioning assembly 70 and/or controller 60 of Fig. 1.

The positioning at 210 may be performed with any suitable timing and/or sequence during methods 200. As examples, the positioning at 210 may be performed prior to the conveying at 220, prior to the detecting at 230, prior to the changing at 240, at least partially concurrently with the changing at 240, as part of the changing at 240, prior to the displaying at 250, prior to the extracting at 260, and/or prior to the optically testing at 270.

Conveying the optical signal at 220 may include conveying any suitable optical signal, which also may be referred to herein as and/or may be an input optical signal, from the optical probe to the calibration structure. In some examples, the optical signal may include and/or be an infrared (IR) optical signal and/or a visible spectrum optical signal. In these examples, the conveying at 220 may include conveying the IR optical signal and/or the visible spectrum optical signal from the optical probe to the calibration structure. As discussed, the gap may spatially separate the optical probe and the calibration structure. With this in mind, the conveying at 220 may include conveying the optical signal across the gap and/or conveying the optical signal from the optical probe to the calibration structure via the gap.

The conveying at 220 may be performed with any suitable timing and/or sequence during methods 200. As examples, the conveying at 220 may be performed subsequent to the positioning at 210, at least partially concurrently with the positioning at 210, prior to the detecting at 230, at least partially concurrently with the detecting at 230, during the detecting at 230, prior to the changing at 240, at least partially concurrently with the changing at 240, during the changing at 240, prior to the displaying at 250, at least partially concurrently with the displaying at 250, prior to the extracting at 260, and/or prior to the optically testing at 270.

Detecting the signal intensity at 230 may include detecting any suitable signal intensity of the optical signal. This may include detecting the signal intensity received by, or as received by, the calibration structure and/or detecting the signal intensity emitted from, or as emitted from, the calibration structure. In some examples, this may include directly detecting the signal intensity of the optical signal. In some examples, this may include detecting the intensity of a fraction, portion, or a coupled portion of the optical signal that couples to the calibration structure, that is conveyed into and/or within the calibration structure, and/or that is emitted from the calibration structure. The portion of the optical signal that is emitted from the calibration structure also may be referred to herein as an output optical signal.

In some examples, the calibration structure may include and/or be an optical detector. In these examples, the detecting at 230 may include detecting with, via, and/or utilizing the calibration structure. In other examples, the optical detector may be separate and/or spaced-apart from the calibration structure. In these examples, the detecting at 230 may include conveying a suitable optical signal, such as the output optical signal, to the optical detector with, via, and/or utilizing the calibration structure; and the detecting at 230 further may include detecting with, via, and/or utilizing the optical detector. Examples of the optical detector are disclosed herein with reference to optical detector 50 of Fig. 1.

In some examples, the detecting at 230 further may include generating a signal intensity output that is indicative of and/or based upon the signal intensity. The signal intensity output may be generated by the calibration structure, may be generated by the optical detector, and/or may be an electrical signal intensity output that takes the form of an electric signal.

The detecting at 230 may be performed with any suitable timing and/or sequence during methods 200. As examples, the detecting at 230 may be performed subsequent to the positioning at 210, at least partially concurrently with the conveying at 220, during the conveying at 220, responsive to the conveying at 220, prior to, at least partially concurrently with, and/or during the changing at 240 and/or the displaying at 250, prior to the extracting at 260, and/or prior to the optically testing at 270.

Changing the relative orientation at 240 may include changing a relative orientation between the optical probe and the calibration structure. The changing at 240 may include changing the relative orientation to produce, to generate, and/or to collect data that is indicative of a representation, or a three-dimensional representation, of the signal intensity as a function of the relative orientation between the optical probe and the calibration structure.

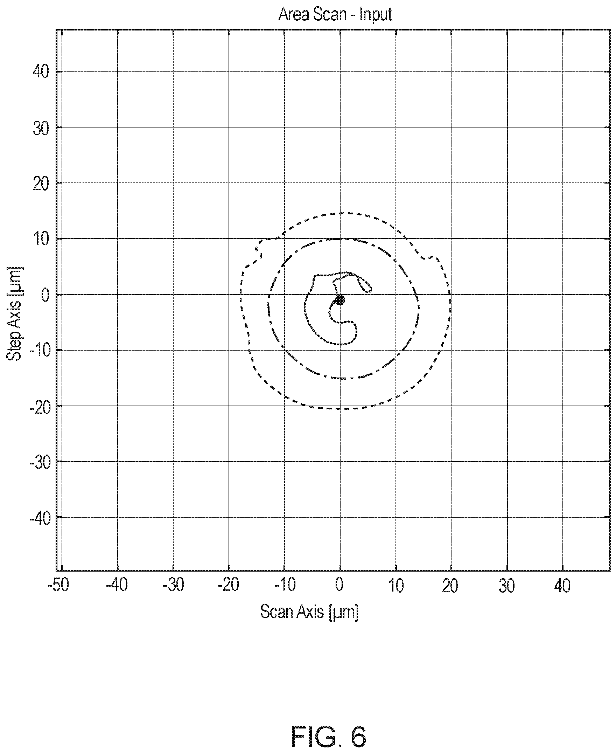

With the above in mind, Fig. 6 illustrates an example of a representation, in the form of a two-dimensional representation, of signal intensity as a function of the relative orientation between the optical probe and the calibration structure for a fixed, or at least substantially fixed, gap magnitude. Stated another way and as an example, Fig. 6 illustrates a representation that may be created by performing the changing at 240 within the Y-Z plane of Fig. 1. In Fig. 6, the dashed contour lines depict relative orientations with a first constant signal intensity, dash-dot contour lines depict relative orientations with a second constant signal intensity, and dotted contour lines depict relative orientations with a third constant signal intensity. The first constant signal intensity is less than the second constant signal intensity, which is less than the third constant signal intensity, and the central circle depicts relative orientation with, or within, a maximum signal intensity.

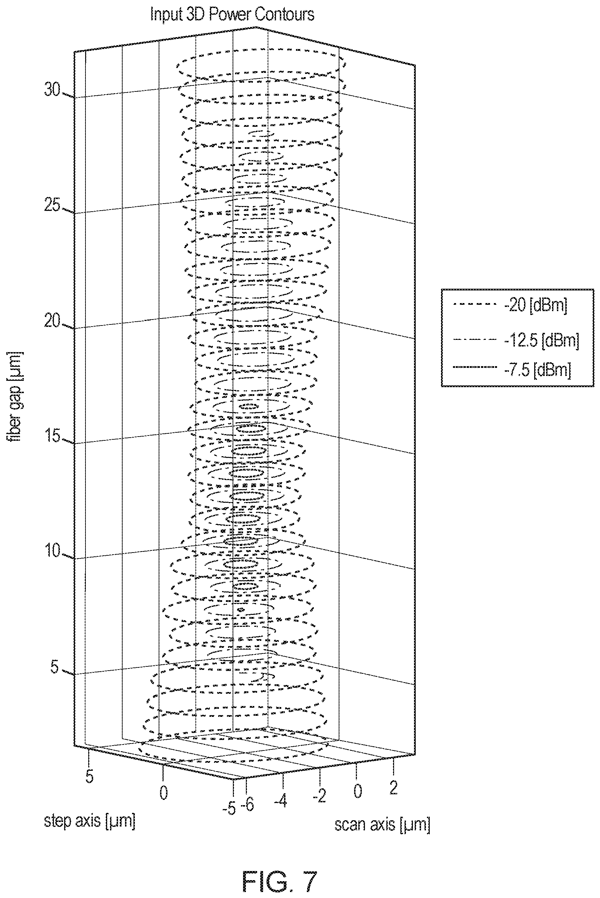

Contour lines generated at a plurality of different, or distinct, gap magnitudes may be combined to generate a representation of signal intensity as a function of the relative orientation between the optical probe and the calibration structure. An example of such a representation is illustrated in Fig. 7, where the vertical axis indicates gap spacing (e.g., the X-axis in Fig. 1) and the horizontal axes indicate relative orientation within a plane (e.g., the Y- and Z-axes of Fig. 1).

The changing at 240 may be accomplished in any suitable manner. As examples, the changing at 240 may include moving the optical probe relative to the calibration structure and/or moving the calibration structure relative to the optical probe. The changing at 240 may be performed utilizing any suitable structure, such as electrically actuated positioning assembly 70 and/or controller 60 of Fig. 1.

In some examples, the changing at 240 may include moving the optical probe and/or the calibration structure to a plurality of spaced-apart, or distinct, relative orientations. In these examples, the detecting at 230 may include detecting the signal intensity while the optical probe and the calibration structure are positioned in at least a subset, or even all, of the plurality of spaced-apart, or distinct, relative orientations. Stated another way, the representation may describe signal intensity at the plurality of spaced-apart, or distinct, relative orientations between the optical probe and the calibration structure. The plurality of spaced-apart, or distinct, relative orientations may extend in two dimensions, as illustrated in Fig. 6, and/or in three dimensions, as illustrated in Fig. 7.

In some examples, the changing at 240 may include scanning, or raster scanning, the optical probe and/or the calibration structure relative to one another in two dimensions and within a first scan plane to generate a correlation between signal intensity and position within the first scan plane. As an example, the scanning may include scanning in the Y-Z plane of Fig. 1. As additional examples, the scanning may include scanning in the X-Y or in the X-Z planes of Fig. 1. An example of the correlation between signal intensity and position within the first scan plane is illustrated in Fig. 6.

In these examples, the changing at 240 also may include moving the optical probe and/or the calibration structure relative to one another in a third dimension that is perpendicular, or at least substantially perpendicular, to the first scan plane. As an example, the moving may include moving in the X-direction of Fig. 1. Also in these examples, the changing at 240 may include repeating the scanning, subsequent to the moving, to generate the correlation between signal intensity and position within a second scan plane that is spaced-apart from the first scan plane. As additional examples, the moving may include moving in the Y or Z directions of Fig. 1. In one specific example, the scanning may include scanning in the X-Y plane and the moving may include moving in the Z-direction. In another specific example, the scanning may include scanning in the X-Z plane and the moving may include moving in the Y-direction. Complementary methods for maintaining gap spacing between an optical probe of probe systems and an optical device are disclosed in U.S. Patent Application No. 16/914,913, the complete disclosure of which is hereby incorporated by reference.

Also in these examples, the changing at 240 may include repeatedly preforming the moving and the repeating the scanning to generate a correlation between signal intensity and position within a plurality of spaced-apart, parallel, and/or non-coplanar scan planes. Examples of the correlation between signal intensity and position within a plurality of spaced-apart, parallel, and/or non-coplanar scan planes are illustrated in Fig. 7 as variations in the contour maps that are spaced-apart along the vertical, or fiber gap, dimension.

In some examples, the conveying at 220 may include conveying the optical signal from the probe to the calibration structure along a signal axis, such as signal axis 45 and/or waveguide signal axis 46 of Fig. 1. In these examples, the third dimension may be parallel, or at least substantially parallel, to the signal axis.

The changing at 240 may be performed with any suitable timing and/or sequence during methods 200. As examples, the changing at 240 may be performed subsequent to the positioning at 210, subsequent to, at least partially concurrently with, and/or during the conveying at 220, the detecting at 230, and/or the displaying at 250, prior to the extracting at 260, and/or prior to the optically testing at 270.

Displaying the representation at 250 may include displaying any suitable representation of signal intensity as the function of relative orientation between the optical probe and the calibration structure. Examples of the representation are illustrated in Figs. 6-7. This may include displaying the representation to an operator of the probe system. The displaying at 250 may include displaying in any suitable manner, including those illustrated in Figs. 6-7. The displaying at 250 may include displaying with, via, and/or utilizing any suitable structure, such as display 66 of Fig. 1.

In some examples, and as illustrated in Fig. 6, the representation may include and/or be a two-dimensional representation of signal intensity as the function of relative orientation between the optical probe and the calibration structure. Such a two-dimensional representation may describe variations in signal intensity within a plane. In some examples, and as illustrated in Fig. 7, the representation may include and/or be a three-dimensional representation of signal intensity as the function of relative orientation between the optical probe and the calibration structure. Such three-dimensional representations may describe variations in signal intensity in three dimensions.

As discussed herein, Figs. 6-7 utilize contour lines to visually depict variations in signal intensity as a function of position. However, other depictions of such variations also are within the scope of the present disclosure. As an example, three-dimensional volumes may be utilized to depict variations in signal intensity instead of, or in addition to, contour lines. As another example, various cross-sectional views of such contour lines and/or three-dimensional volume views also are within the scope of the present disclosure.

The displaying at 250 may be performed with any suitable timing and/or sequence during methods 200. As examples, the displaying at 250 may be performed subsequent to, at least partially concurrently with, and/or during the positioning at 210, the conveying at 220, the detecting at 230, and/or the changing at 240.

Extracting the optical property at 260 may include calculating, determining, and/or estimating any suitable optical property that describes optical coupling between the optical probe and the calibration structure and may be performed in any suitable manner. Examples of the suitable optical property include a focal length of the optical probe, a working distance for the optical probe, a numerical aperture of the optical probe, a beam waist location of the optical signal, a beam waist dimension of the optical signal, a divergence angle of the optical signal, a fluence of the optical signal, and/or an astigmatism of the optical probe.

The extracting at 260 may be based, at least in part, on the signal intensity of the optical signal, as detected during the detecting at 230, and/or on a variation in the signal intensity of the optical signal as a function of relative orientation between the optical probe and the calibration structure. Stated another way, the extracting at 260 may include extracting the optical property from and/or based upon the data that is indicative of the three-dimensional representation of the signal intensity as the function of relative orientation between the optical probe and the calibration structure.

As an example, the extracting at 260 may include extracting contour lines for a given signal intensity and/or for a given set of signal intensities. The contour lines may represent relative orientations between the optical probe and the calibration structure where the signal intensity exhibits the given signal intensity. Stated another way, the contour lines may represent relative orientations between the optical probe and the calibration structure where the signal intensity is constant and/or equal to a fixed value. The contour lines may be extracted, for example, for a plurality of distances between the optical probe and the calibration structure and/or may be utilized to visually represent optical coupling between the optical probe and the calibration structure, such as may be displayed during the displaying at 250. Stated another way, the displaying at 250 may include displaying a three-dimensional map of contour lines that may be extracted and/or determined during the extracting at 260.

As another example, the extracting at 260 may include mathematically analyzing and/or modeling the variation in the signal intensity of the optical signal as the function of relative orientation between the optical probe and the calibration structure to calculate and/or determine one or more parameters and/or metrics of the optical coupling between the optical probe and the calibration structure. Examples of the parameters and/or metrics include a focal distance of the optical probe, a focal distance of the combination of the optical probe and the calibration structure, a beam diameter of the optical signal, a beam diameter of the optical signal as a function of location within the gap between the optical probe and the calibration structure, a numerical aperture of the optical probe, a numerical aperture of a lens of the optical probe, an astigmatism of the optical probe, an astigmatism of the lens of the optical probe, and/or a beam quality factor (M²) of the optical signal.

Optically testing the device under test at 270 may include optically testing the DUT with, via, and/or utilizing the probe system. When methods 200 include the optically testing at 270, the optically testing at 270 may be performed subsequent to the positioning at 210, the conveying at 220, the detecting at 230, the changing at 240, the displaying at 250, and/or the extracting at 260. Stated another way, methods 200 may be utilized to generate the representation of the signal intensity as the function of relative orientation between the optical probe and the calibration structure and/or to extract optical properties prior to performing the optically testing at 270. With this in mind, the representation and/or the optical property may be utilized during and/or to improve the optically testing at 270.

As an example, the optically testing at 270 may include selecting an initial relative orientation between the optical probe and the DUT based, at least in part, on the representation and/or on the optical property. Such methods may be utilized to decrease and/or minimize insertion loss due to the optical coupling between the optical probe and the DUT. Additionally or alternatively, such methods may be utilized to quantify the insertion loss and/or to account for, or quantify, variability among optical probes that may be utilized by the probe system.

As another example, the optically testing at 270 may include quantifying optical performance of the DUT based, at least in part, on the optically testing and also on the representation and/or the optical property. Such methods may be utilized to quantify, to deconvolute, and/or to separate contributions to changes in the optical signal that is utilized during the optically testing, which may be caused by optical coupling between the optical probe and the DUT, from changes in the optical signal that may be caused by the DUT itself.

Methods 200 may be performed in any suitable manner and/or utilizing any suitable structure. Examples of structures that may be utilized to perform methods 200 and/or of ways in which these structures may be utilized to perform methods 200 are discussed herein with reference to probe system 10 of Figs. 1-4.

In one example, and as illustrated in Fig. 1, the calibration structure may include a device optical fiber. The device optical fiber may be configured to receive the optical signal from the optical probe. In some such examples, the optical probe may include and/or be a first optical probe of the probe system, and the device optical fiber may include and/or be a second optical probe of the probe system. In some such examples, the probe system may include the optical detector, and the device optical fiber may be configured to convey the optical signal, or a coupled portion of the optical signal, to the optical detector.

In this example, the positioning at 210 may include positioning the optical probe and the device optical fiber relative to one another. Also in this example, the conveying at 220 may include conveying the optical signal from the optical probe to the device optical fiber, such as along a waveguide signal axis, and/or the detecting at 230 may include detecting the optical signal, or the coupled portion of the optical signal, with the optical detector of the probe system. Also in this example, the changing at 240 may include changing the relative orientation between the optical probe and the device optical fiber, such as by moving the optical probe relative to the device optical fiber and/or moving the device optical fiber relative to the optical probe.

In another example, and as illustrated in Figs. 1-2, the calibration structure may include a first grating coupler, a second grating coupler, and a waveguide. In this example, the probe system may include the first probe and the second probe. Also in this example, the first grating coupler may be configured to receive the optical signal, or a coupled portion of the optical signal, from the first optical probe and/or to convey the optical signal to the waveguide. The waveguide may be configured to receive the optical signal, or the coupled portion of the optical signal, and to convey the optical signal to the second grating coupler. The second grating coupler may be configured to receive the optical signal, or the coupled portion of the optical signal, from the waveguide and/or to convey the optical signal to the second optical probe. Also in this example, the probe system may include the optical detector, and the second optical probe may be configured to convey the optical signal, or the coupled portion of the optical signal, to the optical detector.

In this example, the positioning at 210 may include positioning the first optical probe relative to the first grating coupler and/or positioning the second optical probe relative to the second grating coupler. Also in this example, the conveying at 220 may include conveying the optical signal, or the coupled portion of the optical signal, from the first optical probe to the optical detector via the first grating coupler, the waveguide, the second grating coupler, and the second optical probe. The conveying the optical signal from the first optical probe to the first grating coupler may include conveying along a signal axis. Also in this example, the detecting at 230 may include detecting the optical signal, or the coupled portion of the optical signal, with the optical detector of the probe system. Also in this example, the changing at 240 may include changing the relative orientation between the first optical probe and the first grating coupler, such as by moving the first optical probe relative to the first grating coupler and/or moving the first grating coupler relative to the first optical probe.

In another example, and as illustrated in Figs. 1 and 3, the calibration structure may include a waveguide. In this example, the probe system may include the first probe and the second probe. Also in this example, the waveguide may be configured to receive the optical signal, or a coupled portion of the optical signal, from the first optical probe and/or to convey the optical signal to the second optical probe. The waveguide may be accessible to the first optical probe and/or to the second optical probe via a vertical surface of a substrate that includes the calibration structure and/or may extend at least substantially parallel to an upper surface of the substrate. Examples of the vertical surface include a substrate edge of the substrate and/or a trench that may be defined within the substrate. The optical signal may be conveyed from the first optical probe to the waveguide along a waveguide signal axis. Also in this example, the probe system may include the optical detector, and the second optical probe may be configured to convey the optical signal, or the coupled portion of the optical signal, to the optical detector.

In this example, the positioning at 210 may include positioning the first optical probe relative to the waveguide, or to a first end of the waveguide, and/or positioning the second optical probe relative to the waveguide, or to a second, opposed, end of the waveguide. Also in this example, the conveying at 220 may include conveying the optical signal, or the coupled portion of the optical signal, from the first optical probe to the optical detector via the waveguide and the second optical probe. Also in this example, the detecting at 230 may include detecting the optical signal, or the coupled portion of the optical signal, with the optical detector of the probe system. Also in this example, the changing at 240 may include changing the relative orientation between the first optical probe and the waveguide, such as by moving the first optical probe relative to the waveguide and/or moving the waveguide relative to the first optical probe.

In another example, and as illustrated in Figs. 1 and 4, the calibration structure may include an obstructive calibration structure in the form of a knife-edge calibration structure. In this example, the probe system and/or the calibration structure may include the optical detector, and the knife-edge calibration structure and the optical detector may be positioned, relative to one another, such that the optical detector extends around an external periphery of the knife-edge calibration structure and/or such that the knife-edge calibration structure blocks the optical signal from being incident upon a region of the optical detector that is internal to the external periphery of the knife-edge calibration structure but permits the optical signal to be incident upon a region of the optical detector that extends around, or external to, the external periphery of the knife-edge calibration structure.

In this example, the positioning at 210 may include positioning the optical probe relative to the knife-edge calibration structure. Also in this example, the conveying at 220 may include conveying the optical signal from the optical probe to the optical detector while selectively blocking a portion of the optical signal from being incident upon the optical detector with, via, and/or utilizing the knife-edge calibration structure. Also in this example, the detecting at 230 may include detecting the optical signal, or a fraction of the optical signal that reaches the optical detector, with the optical detector.

Also in this example, the changing at 240 may include changing the relative orientation between the optical probe and the combination of the knife-edge calibration structure and the optical detector, such as by moving the optical probe relative to the knife-edge calibration structure and also relative to the optical detector and/or moving the knife-edge calibration structure and the optical detector relative to the optical probe. More specifically, the changing at 240 may include scanning the optical signal across the optical detector and also across the knife-edge calibration structure, such as along a plurality of different scan directions. The scanning the optical signal across the optical detector and also across the knife-edge calibration structure along the plurality of different scan directions may be utilized to generate a corresponding plurality of one-dimensional representations of signal intensity as a function of relative orientation and scan direction. These methods further may include utilizing the plurality of one-dimensional representations of signal intensity as the function of relative orientation and scan direction to generate the representation of the intensity as the function of relative orientation between the optical probe and the combination of the knife-edge calibration structure and the optical detector.

In another example, and as illustrated in Figs. 1 and 4, the calibration structure may include an obstructive calibration structure in the form of a pinhole calibration structure. In this example, the probe system and/or the calibration structure may include the optical detector, and the optical probe, the pinhole calibration structure, and the optical detector may be positioned, relative to one another, such that the optical detector is incident upon the optical detector via the pinhole calibration structure, or via a pinhole of the pinhole calibration structure.

In this example, the positioning at 210 may include positioning the optical probe relative to the pinhole calibration structure. Also in this example, the conveying at 220 may include conveying the optical signal from the optical probe to the optical detector while selectively blocking a portion of the optical signal from being incident upon the optical detector with, via, and/or utilizing the pinhole structure. Also in this example, the detecting at 230 may include detecting the optical signal, or a fraction of the optical signal that reaches the optical detector, with the optical detector.

Also in this example, the changing at 240 may include changing the relative orientation between the optical probe and the combination of the pinhole calibration structure and the optical detector, such as by moving the optical probe relative to the pinhole calibration structure and also relative to the optical detector and/or moving the pinhole calibration structure and the optical detector relative to the optical probe. More specifically, the changing at 240 may include scanning the optical signal across the optical detector and also across the pinhole calibration structure, such as along a plurality of different scan directions in a manner that may be at least substantially similar to that discussed herein with reference to the knife-edge calibration structure. The scanning the optical signal across the optical detector and also across the pinhole calibration structure along the plurality of different scan directions may be utilized to generate a corresponding plurality of one-dimensional representations of signal intensity as a function of relative orientation and scan direction. These methods further may include utilizing the plurality of one-dimensional representations of signal intensity as the function of relative orientation and scan direction to generate the representation of the intensity as the function of relative orientation between the optical probe and the combination of the pinhole calibration structure and the optical detector.

As used herein, the phrase "optical signal" may refer to any suitable signal that is transferred and/or conveyed via photons. Optical signals, according to the present disclosure, may include photons of any wavelength, such as may be suitable for receipt by, detection by, transmission by, and/or emission from DUTs 150 and/or calibration structures 160. Examples of optical signals include laser light and/or electromagnetic radiation. Additional examples of optical signals include x-ray radiation, ultraviolet radiation, visible light, infrared radiation, and/or microwave radiation.

In the present disclosure, several of the illustrative, non-exclusive examples have been discussed and/or presented in the context of flow diagrams, or flow charts, in which the methods are shown and described as a series of blocks, or steps. Unless specifically set forth in the accompanying description, it is within the scope of the present disclosure that the order of the blocks may vary from the illustrated order in the flow diagram, including with two or more of the blocks (or steps) occurring in a different order and/or concurrently. It is also within the scope of the present disclosure that the blocks, or steps, may be implemented as logic, which also may be described as implementing the blocks, or steps, as logics. In some applications, the blocks, or steps, may represent expressions and/or actions to be performed by functionally equivalent circuits or other logic devices. The illustrated blocks may, but are not required to, represent executable instructions that cause a computer, processor, and/or other logic device to respond, to perform an action, to change states, to generate an output or display, and/or to make decisions.

As used herein, the term "and/or" placed between a first entity and a second entity means one of (1) the first entity, (2) the second entity, and (3) the first entity and the second entity. Multiple entities listed with "and/or" should be construed in the same manner, i.e., "one or more" of the entities so conjoined. Other entities may optionally be present other than the entities specifically identified by the "and/or" clause, whether related or unrelated to those entities specifically identified. Thus, as a non-limiting example, a reference to "A and/or B," when used in conjunction with open-ended language such as "comprising" may refer, in one embodiment, to A only (optionally including entities other than B); in another embodiment, to B only (optionally including entities other than A); in yet another embodiment, to both A and B (optionally including other entities). These entities may refer to elements, actions, structures, steps, operations, values, and the like.

As used herein, the phrase "at least one," in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that entities may optionally be present other than the entities specifically identified within the list of entities to which the phrase "at least one" refers, whether related or unrelated to those entities specifically identified. Thus, as a non-limiting example, "at least one of A and B" (or, equivalently, "at least one of A or B," or, equivalently "at least one of A and/or B") may refer, in one embodiment, to at least one, optionally including more than one, A, with no B present (and optionally including entities other than B); in another embodiment, to at least one, optionally including more than one, B, with no A present (and optionally including entities other than A); in yet another embodiment, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

In the event that any patents, patent applications, or other references are incorporated by reference herein and (1) define a term in a manner that is inconsistent with and/or (2) are otherwise inconsistent with, either the non-incorporated portion of the present disclosure or any of the other incorporated references, the non-incorporated portion of the present disclosure shall control, and the term or incorporated disclosure therein shall only control with respect to the reference in which the term is defined and/or the incorporated disclosure was present originally.

As used herein the terms "adapted" and "configured" mean that the element, component, or other subject matter is designed and/or intended to perform a given function. Thus, the use of the terms "adapted" and "configured" should not be construed to mean that a given element, component, or other subject matter is simply "capable of" performing a given function but that the element, component, and/or other subject matter is specifically selected, created, implemented, utilized, programmed, and/or designed for the purpose of performing the function. It is also within the scope of the present disclosure that elements, components, and/or other recited subject matter that is recited as being adapted to perform a particular function may additionally or alternatively be described as being configured to perform that function, and vice versa.

As used herein, the phrase, "for example," the phrase, "as an example," and/or simply the term "example," when used with reference to one or more components, features, details, structures, embodiments, and/or methods according to the present disclosure, are intended to convey that the described component, feature, detail, structure, embodiment, and/or method is an illustrative, non-exclusive example of components, features, details, structures, embodiments, and/or methods according to the present disclosure. Thus, the described component, feature, detail, structure, embodiment, and/or method is not intended to be limiting, required, or exclusive/exhaustive; and other components, features, details, structures, embodiments, and/or methods, including structurally and/or functionally similar and/or equivalent components, features, details, structures, embodiments, and/or methods, are also within the scope of the present disclosure.

As used herein, "at least substantially," when modifying a degree or relationship, may include not only the recited "substantial" degree or relationship, but also the full extent of the recited degree or relationship. A substantial amount of a recited degree or relationship may include at least 75% of the recited degree or relationship. For example, an object that is at least substantially formed from a material includes objects for which at least 75% of the objects are formed from the material and also includes objects that are completely formed from the material. As another example, a first length that is at least substantially as long as a second length includes first lengths that are within 75% of the second length and also includes first lengths that are as long as the second length.

### Industrial Applicability

The systems and methods disclosed herein are applicable to the optical device manufacturing and test industries.

It is believed that the disclosure set forth above encompasses multiple distinct inventions with independent utility. While each of these inventions has been disclosed in its preferred form, the specific embodiments thereof as disclosed and illustrated herein are not to be considered in a limiting sense as numerous variations are possible. The subject matter of the inventions includes all novel and non-obvious combinations and subcombinations of the various elements, features, functions and/or properties disclosed herein. Similarly, where the claims recite "a" or "a first" element or the equivalent thereof, such claims should be understood to include incorporation of one or more such elements, neither requiring nor excluding two or more such elements.

It is believed that the following claims particularly point out certain combinations and subcombinations that are directed to one of the disclosed inventions and are novel and non-obvious. Inventions embodied in other combinations and subcombinations of features, functions, elements and/or properties may be claimed through amendment of the present claims or presentation of new claims in this or a related application. Such amended or new claims, whether they are directed to a different invention or directed to the same invention, whether different, broader, narrower, or equal in scope to the original claims, are also regarded as included within the subject matter of the inventions of the present disclosure.

## Claims

1. A probe system (10), comprising:
a probe assembly (18) including an optical probe (20);
a support surface (32) configured to support a substrate (140) that includes a device under test (DUT) (150) that includes an optical device (152);
a signal generation and analysis assembly (40) configured to generate an optical signal (42) and to provide the optical signal (42) to the optical device (152) via the optical probe (20);
an electrically actuated positioning assembly (70) configured to selectively adjust a relative orientation between the optical probe (20) and the DUT (150);
a calibration structure (160) configured to receive the optical signal (42);
an optical detector (50) configured to detect a signal intensity of the optical signal (42); and
a controller (60) programmed to control the operation of the probe system (10) by:
(i) positioning (210) the optical probe (20) and the calibration structure (160) proximate one another;
(ii) conveying (220) the optical signal (42) from the optical probe (20) to the calibration structure;
(iii) during the conveying (220), detecting (230) the signal intensity of the optical signal (42); and
(iv) during the conveying (220) and also during the detecting (230), changing (240) the relative orientation between the optical probe (20) and the calibration structure (160) to generate a two-dimensional representation of the signal intensity as a function of the relative orientation between the optical probe (20) and the calibration structure (160), wherein the changing (240) includes scanning the optical probe (20) and the calibration structure (160) relative to one another in two dimensions and within a first scan plane to generate a correlation between the signal intensity and position within the first scan plane, **characterized in that** the changing (240) further includes:
(i) moving the optical probe (20) and the calibration structure (160) relative to one another in a third dimension that is at least substantially perpendicular to the first scan plane; and
(ii) repeating the scanning to generate the correlation between the signal intensity and position within a second scan plane that is spaced-apart from the first scan plane.

2. The probe system (10) of claim 1, wherein the conveying (220) the optical signal (42) includes conveying (220) the optical signal (42) across a gap that spatially separates the optical probe (20) and the calibration structure (160).

3. The probe system (10) of any of claims 1-2, wherein the controller (60) further is programmed to optically test (270) the device under test (DUT) (150) and to at least one of:
(i) select an initial relative orientation between the optical probe (20) and the DUT (150) based, at least in part, on the two-dimensional representation of the signal intensity as the function of relative orientation between the optical probe (20) and the calibration structure (160); and
(ii) quantify optical performance of the DUT (150) based, at least in part, on the optical test and also on the two-dimensional representation of the signal intensity as the function of relative orientation between the optical probe (20) and the calibration structure (160).

4. The probe system (10) of any of claims 1-3, wherein the calibration structure (160) includes a device optical fiber configured to receive the optical signal (42) from the optical probe (20), and further wherein the device optical fiber is configured to convey a coupled portion of the optical signal (42) to the optical detector (50).

5. The probe system (10) of any of claims 1-4, wherein the calibration structure (160) includes:
(i) a first grating coupler (101) configured to receive a coupled portion of the optical signal (42) from the optical probe (20);
(ii) a waveguide (154) configured to receive the coupled portion of the optical signal (42) from the first grating coupler (101); and
(iii) a second grating coupler (102) configured to receive the coupled portion of the optical signal (42) from the waveguide (154);
optionally wherein the optical detector (50) is configured to receive the coupled portion of the optical signal (42) from the second grating coupler (102); and
optionally wherein the optical probe (20) is a first optical probe (21), wherein the probe system (10) further includes a second optical probe (22), wherein the second optical probe (22) is configured to receive the coupled portion of the optical signal (42) from the second grating coupler (102) and to convey the coupled portion of the optical signal (42) to the optical detector (50).

6. The probe system (10) of any of claims 1-5, wherein the calibration structure (160) includes a waveguide (154) configured to receive a coupled portion of the optical signal (42) from the optical probe (20), optionally
wherein the waveguide (154) at least one of:
(i) is accessible to the optical probe (20 via an edge of the substrate (140) that includes the calibration structure (160);
(ii) is accessible to the optical probe (20) via a trench that extends into the substrate (140); and
(iii) extends at least substantially parallel to an upper surface of the substrate (140);
optionally wherein the optical detector (50) is configured to receive the coupled portion of the optical signal (42) from the waveguide (154);
and further optionally wherein the optical probe (20) is a first optical probe (21), wherein the probe system (10) further includes a second optical probe (22), wherein the second optical probe (22) is configured to receive the coupled portion of the optical signal (42) from the waveguide (154) and to convey the coupled portion of the optical signal (42) to the optical detector (50).

7. The probe system (10) of any of claims 1-6, wherein the calibration structure (160) includes at least one of:
(i) a knife-edge calibration structure; and
(ii) a pinhole calibration structure.

8. The probe system (10) of any of claims 1-7, wherein the controller (60) further is programmed to extract an optical property that describes optical coupling between the optical probe (20) and the calibration structure (160), optionally wherein the optical property includes at least one of:
(i) a focal length of the optical probe (20);
(ii) a working distance for the optical probe (20);
(iii) a numerical aperture of the optical probe (20);
(iv) a beam waist location of the optical signal (42);
(v) a beam waist dimension of the optical signal (42);
(vi) a divergence angle of the optical signal (42);
(vii) a fluence of the optical signal (42); and
(viii) an astigmatism of the optical probe (20).

9. A method (200) of characterizing optical coupling between an optical probe (20) of a probe system (10) and a calibration structure (160), the method (200) comprising:
positioning (210) the optical probe (20) and the calibration structure (160) proximate one another;
conveying (220) an optical signal (42) from the optical probe (20) to the calibration structure (160);
during the conveying (220), detecting (230) a signal intensity of the optical signal (42); and during the conveying (220) and also during the detecting (230), changing (240) a relative orientation between the optical probe (20) and the calibration structure (160) to generate a two-dimensional representation of the signal intensity as a function of the relative orientation between the optical probe (20) and the calibration structure (160), wherein the changing (240) includes scanning the optical probe (20) and the calibration structure (160) relative to one another in two dimensions and within a first scan plane to generate a correlation between the signal intensity and position within the first scan plane, **characterized in that** the changing (240) further includes:
(i) moving the optical probe (20) and the calibration structure (160) relative to one another in a third dimension that is perpendicular to the first scan plane; and
(ii) repeating the scanning to generate the correlation between the signal intensity and position within a second scan plane that is spaced-apart from the first scan plane.

10. The method (200) of claim 9, wherein the method (200) includes repeatedly performing the moving and the repeating the scanning to generate the correlation between the signal intensity and position within a plurality of spaced-apart scan planes.

11. The method (200) of any of claims 9-10, wherein the method (200) further includes optically testing (270) a device under test (DUT) (150), and further wherein the optically testing (270) includes at least one of:
(i) selecting an initial relative orientation between the optical probe (20) and the DUT (150) based, at least in part, on the two-dimensional representation of the signal intensity as the function of relative orientation between the optical probe (20) and the calibration structure (160); and
(ii) quantifying optical performance of the DUT (150) based, at least in part, on the optically testing (270) and also on the two-dimensional representation of the signal intensity as the function of relative orientation between the optical probe (20) and the calibration structure (160).

12. The method (200) of any of claims 9-11, wherein the method (200) further includes extracting (260) an optical property that describes optical coupling between the optical probe (20) and the calibration structure (160), wherein the optical property includes at least one of:
(i) a focal length of the optical probe (20);
(ii) a working distance for the optical probe (20);
(iii) a numerical aperture of the optical probe (20);
(iv) a beam waist location of the optical signal (42);
(v) a beam waist dimension of the optical signal (42);
(vi) a divergence angle of the optical signal (42);
(vii) a fluence of the optical signal (42); and
(viii) an astigmatism of the optical probe (20).

13. Non-transitory computer-readable storage media **characterized in that** it includes computer-readable instructions that, when executed, direct a probe system (10) to perform the method (200) of any of claims 9-12.

## Patentansprüche

1. Sondensystem (10), umfassend:
eine Sondenanordnung (18), die eine optische Sonde (20) aufweist;
eine Stützfläche (32), die dazu ausgelegt ist, ein Substrat (140) zu stützen, das eine zu testende Vorrichtung (DUT) (150) aufweist, die eine optische Vorrichtung (152) aufweist;
eine Signalerzeugungs- und Analyseanordnung (40), die dazu ausgelegt ist, ein optisches Signal (42) zu erzeugen und das optische Signal (42) über die optische Sonde (20) für die optische Vorrichtung (152) bereitzustellen;
eine elektrisch betätigte Positionierungsanordnung (70), die dazu ausgelegt ist, gezielt eine relative Ausrichtung zwischen der optischen Sonde (20) und der DUT (150) einzustellen;
eine Kalibrierungsstruktur (160), die dazu ausgelegt ist, das optische Signal (42) zu empfangen;
einen optischen Detektor (50), der dazu ausgelegt ist, eine Signalintensität des optischen Signals (42) zu detektieren; und
eine Steuerung (60), die dazu programmiert ist, den Betrieb des Sondensystems (10) zu steuern durch:
(i) Positionieren (210) der optischen Sonde (20) und der Kalibrierungsstruktur (160) nahe beieinander;
(ii) Transportieren (220) des optischen Signals (42) von der optischen Sonde (20) zu der Kalibrierungsstruktur;
(iii) Detektieren (230) der Signalintensität des optischen Signals (42) während des Transportierens (220); und
(iv) Ändern (240), während des Transportierens (220) und auch während des Detektierens (230), der relativen Orientierung zwischen der optischen Sonde (20) und der Kalibrierungsstruktur (160), um eine zweidimensionale Darstellung der Signalintensität als eine Funktion der relativen Orientierung zwischen der optischen Sonde (20) und der Kalibrierungsstruktur (160) zu erzeugen, wobei das Ändern (240) Scannen der optischen Sonde (20) und der Kalibrierungsstruktur (160) relativ zueinander in zwei Dimensionen und innerhalb einer ersten Scanebene beinhaltet, um eine Korrelation zwischen der Signalintensität und der Position innerhalb der ersten Scanebene zu erzeugen,
**dadurch gekennzeichnet, dass** das Ändern (240) ferner Folgendes umfasst:
(i) Bewegen der optischen Sonde (20) und der Kalibrierungsstruktur (160) relativ zueinander in einer dritten Dimension, die mindestens im Wesentlichen senkrecht zu der ersten Scanebene ist; und
(ii) Wiederholen des Scannens, um die Korrelation zwischen der Signalintensität und der Position innerhalb einer zweiten Scanebene zu erzeugen, die von der ersten Scanebene beabstandet ist.

2. Sondensystem (10) nach Anspruch 1, wobei das Transportieren (220) des optischen Signals (42) Transportieren (220) des optischen Signals (42) über einen Spalt beinhaltet, der die optische Sonde (20) und die Kalibrierungsstruktur (160) räumlich trennt.

3. Sondensystem (10) nach einem der Ansprüche 1-2, wobei die Steuerung (60) ferner programmiert ist zum optischen Testen (270) der zu testenden Vorrichtung (DUT) (150) und zu mindestens einem aus Folgendem:
(i) Auswählen einer anfänglichen relativen Orientierung zwischen der optischen Sonde (20) und der DUT (150) zumindest teilweise basierend auf der zweidimensionalen Darstellung der Signalintensität als Funktion der relativen Orientierung zwischen der optischen Sonde (20) und der Kalibrierungsstruktur (160); und
(ii) Quantifizieren der optischen Leistungsfähigkeit der DUT (150) zumindest teilweise basierend auf dem optischen Test und auch auf der zweidimensionalen Darstellung der Signalintensität als Funktion der relativen Orientierung zwischen der optischen Sonde (20) und der Kalibrierungsstruktur (160).

4. Sondensystem (10) nach einem der Ansprüche 1-3, wobei die Kalibrierungsstruktur (160) eine optische Vorrichtungsfaser beinhaltet, die dazu ausgelegt ist, das optische Signal (42) von der optischen Sonde (20) zu empfangen, und wobei ferner die optische Vorrichtungsfaser dazu ausgelegt ist, einen gekoppelten Teil des optischen Signals (42) zu dem optischen Detektor (50) zu transportieren.

5. Sondensystem (10) nach einem der Ansprüche 1-4, wobei die Kalibrierungsstruktur (160) Folgendes umfasst:
(i) einen ersten Gitterkoppler (101), der dazu ausgelegt ist, einen gekoppelten Teil des optischen Signals (42) von der optischen Sonde (20) zu empfangen;
(ii) einen Wellenleiter (154), der dazu ausgelegt ist, den gekoppelten Teil des optischen Signals (42) von dem ersten Gitterkoppler (101) zu empfangen; und
(iii) einen zweiten Gitterkoppler (102), der dazu ausgelegt ist, den gekoppelten Teil des optischen Signals (42) von dem Wellenleiter (154) zu empfangen;
wobei optional der optische Detektor (50) dazu ausgelegt ist, den gekoppelten Teil des optischen Signals (42) von dem zweiten Gitterkoppler (102) zu empfangen; und
wobei optional die optische Sonde (20) eine erste optische Sonde (21) ist, wobei das Sondensystem (10) ferner eine zweite optische Sonde (22) beinhaltet, wobei die zweite optische Sonde (22) dazu ausgelegt ist, den gekoppelten Teil des optischen Signals (42) von dem zweiten Gitterkoppler (102) zu empfangen und den gekoppelten Teil des optischen Signals (42) zu dem optischen Detektor (50) zu transportieren.

6. Sondensystem (10) nach einem der Ansprüche 1-5, wobei die Kalibrierungsstruktur (160) einen Wellenleiter (154) aufweist, der dazu ausgelegt ist, einen gekoppelten Teil des optischen Signals (42) von der optischen Sonde (20) zu empfangen,
wobei optional der Wellenleiter (154):
(i) für die optische Sonde (20) über eine Kante des Substrats (140) zugänglich ist, die die Kalibrierungsstruktur (160) beinhaltet; und/oder
(ii) für die optische Sonde (20) über einen Graben zugänglich ist, der sich in das Substrat (140) erstreckt; und/oder
(iii) sich mindestens im Wesentlichen parallel zu einer oberen Oberfläche des Substrats (140) erstreckt;
wobei optional der optische Detektor (50) dazu ausgelegt ist, den gekoppelten Teil des optischen Signals (42) von dem Wellenleiter (154) zu empfangen;
und wobei ferner optional die optische Sonde (20) eine erste optische Sonde (21) ist, wobei das Sondensystem (10) ferner eine zweite optische Sonde (22) aufweist, wobei die zweite optische Sonde (22) dazu ausgelegt ist, den gekoppelten Teil des optischen Signals (42) von dem Wellenleiter (154) zu empfangen und den gekoppelten Teil des optischen Signals (42) zu dem optischen Detektor (50) zu transportieren.

7. Sondensystem (10) nach einem der Ansprüche 1-6, wobei die Kalibrierungsstruktur (160) mindestens eines aus Folgendem beinhaltet:
(i) eine Messerschneiden-Kalibrierungsstruktur; und
(ii) eine Lochblenden-Kalibrierungsstruktur.

8. Sondensystem (10) nach einem der Ansprüche 1-7, wobei die Steuerung (60) ferner dazu programmiert ist, eine optische Eigenschaft zu extrahieren, die eine optische Kopplung zwischen der optischen Sonde (20) und der Kalibrierungsstruktur (160) beschreibt, wobei die optische Eigenschaft optional mindestens eines aus Folgendem umfasst:
(i) eine Brennweite der optischen Sonde (20);
(ii) einen Arbeitsabstand für die optische Sonde (20);
(iii) eine numerische Apertur der optischen Sonde (20);
(iv) eine Strahltaillenposition des optischen Signals (42);
(v) eine Strahltaillenabmessung des optischen Signals (42);
(vi) einen Divergenzwinkel des optischen Signals (42);
(vii) eine Fluenz des optischen Signals (42); und
(viii) einen Astigmatismus der optischen Sonde (20).

9. Verfahren (200) zum Charakterisieren einer optischen Kopplung zwischen einer optischen Sonde (20) eines Sondensystems (10) und einer Kalibrierungsstruktur (160), wobei das Verfahren (200) Folgendes umfasst:
Positionieren (210) der optischen Sonde (20) und der Kalibrierungsstruktur (160) nahe beieinander;
Transportieren (220) eines optischen Signals (42) von der optischen Sonde (20) zu der Kalibrierungsstruktur (160);
Detektieren (230) einer Signalintensität des optischen Signals (42) während des Transportierens (220); und
Ändern (240), während des Transportierens (220) und auch während des Detektierens (230), einer relativen Orientierung zwischen der optischen Sonde (20) und der Kalibrierungsstruktur (160), um eine zweidimensionale Darstellung der Signalintensität als eine Funktion der relativen Orientierung zwischen der optischen Sonde (20) und der Kalibrierungsstruktur (160) zu erzeugen, wobei das Ändern (240) Scannen der optischen Sonde (20) und der Kalibrierungsstruktur (160) relativ zueinander in zwei Dimensionen und innerhalb einer ersten Scanebene beinhaltet, um eine Korrelation zwischen der Signalintensität und der Position innerhalb der ersten Scanebene zu erzeugen,
**dadurch gekennzeichnet, dass** das Ändern (240) ferner Folgendes umfasst:
(i) Bewegen der optischen Sonde (20) und der Kalibrierungsstruktur (160) relativ zueinander in einer dritten Dimension, die senkrecht zu der ersten Scanebene ist; und
(ii) Wiederholen des Scannens, um die Korrelation zwischen der Signalintensität und der Position innerhalb einer zweiten Scanebene zu erzeugen, die von der ersten Scanebene beabstandet ist.

10. Verfahren (200) nach Anspruch 9, wobei das Verfahren (200) wiederholtes Durchführen des Bewegens und des Wiederholens des Scannens beinhaltet, um die Korrelation zwischen der Signalintensität und der Position innerhalb mehrerer beabstandeter Scanebenen zu erzeugen.

11. Verfahren (200) nach einem der Ansprüche 9-10, wobei das Verfahren (200) ferner optisches Testen (270) einer zu testenden Vorrichtung (DUT) (150) beinhaltet und wobei ferner das optische Testen (270) mindestens eines aus Folgendem beinhaltet:
(i) Auswählen einer anfänglichen relativen Orientierung zwischen der optischen Sonde (20) und der DUT (150) zumindest teilweise basierend auf der zweidimensionalen Darstellung der Signalintensität als Funktion der relativen Orientierung zwischen der optischen Sonde (20) und der Kalibrierungsstruktur (160); und
(ii) Quantifizieren der optischen Leistungsfähigkeit der DUT (150) mindestens teilweise basierend auf dem optischen Testen (270) und auch auf der zweidimensionalen Darstellung der Signalintensität als Funktion der relativen Orientierung zwischen der optischen Sonde (20) und der Kalibrierungsstruktur (160).

12. Verfahren (200) nach einem der Ansprüche 9-11, wobei das Verfahren (200) ferner Extrahieren (260) einer optischen Eigenschaft beinhaltet, die eine optische Kopplung zwischen der optischen Sonde (20) und der Kalibrierungsstruktur (160) beschreibt, wobei die optische Eigenschaft mindestens eines aus Folgendem umfasst:
(i) eine Brennweite der optischen Sonde (20);
(ii) einen Arbeitsabstand für die optische Sonde (20);
(iii) eine numerische Apertur der optischen Sonde (20);
(iv) eine Strahltaillenposition des optischen Signals (42);
(v) eine Strahltaillenabmessung des optischen Signals (42);
(vi) einen Divergenzwinkel des optischen Signals (42);
(vii) eine Fluenz des optischen Signals (42); und
(viii) einen Astigmatismus der optischen Sonde (20).

13. Nichtflüchtige computerlesbare Speicherungsmedien, **dadurch gekennzeichnet, dass** sie computerlesbare Anweisungen beinhalten, die, wenn sie ausgeführt werden, ein Sondensystem (10) anweisen, das Verfahren (200) nach einem der Ansprüche 9-12 durchzuführen.

## Revendications

1. Système de sondes (10), comprenant :
un ensemble sonde (18) comportant une sonde optique (20) ;
une surface d'appui (32) configurée pour porter un substrat (140) qui comporte un dispositif testé (DUT) (150) qui comporte un dispositif optique (152) ;
un ensemble (40) de génération et d'analyse de signal configuré pour générer un signal optique (42) et pour fournir le signal optique (42) au dispositif optique (152) par l'intermédiaire de la sonde optique (20) ;
un ensemble de positionnement (70) actionné électriquement configuré pour ajuster sélectivement une orientation relative entre la sonde optique (20) et le DUT (150) ;
une structure d'étalonnage (160) configurée pour recevoir le signal optique (42) ;
un détecteur optique (50) configuré pour détecter une intensité de signal du signal optique (42) ; et
un dispositif de commande (60) programmé pour commander le fonctionnement du système de sondes (10) par :
(i) le positionnement (210) de la sonde optique (20) et de la structure d'étalonnage (160) à proximité l'une de l'autre ;
(ii) l'acheminement (220) du signal optique (42) de la sonde optique (20) à la structure d'étalonnage ;
(iii) pendant l'acheminement (220), la détection (230) de l'intensité de signal du signal optique (42) ; et
(iv) pendant l'acheminement (220) et également pendant la détection (230), la modification (240) de l'orientation relative entre la sonde optique (20) et la structure d'étalonnage (160) pour générer une représentation bidimensionnelle de l'intensité de signal sous la forme d'une fonction de l'orientation relative entre la sonde optique (20) et la structure d'étalonnage (160), dans lequel la modification (240) comprend un balayage de la sonde optique (20) et de la structure d'étalonnage (160) l'une par rapport à l'autre en deux dimensions et à l'intérieur d'un premier plan de balayage pour générer une corrélation entre l'intensité de signal et la position à l'intérieur du premier plan de balayage, **caractérisé en ce que** la modification (240) comprend en outre :
(i) le déplacement de la sonde optique (20) et de la structure d'étalonnage (160) l'une par rapport à l'autre dans une troisième dimension qui est au moins sensiblement perpendiculaire au premier plan de balayage ; et
(ii) la répétition du balayage pour générer la corrélation entre l'intensité de signal et la position à l'intérieur d'un deuxième plan de balayage espacé du premier plan de balayage.

2. Système de sondes (10) selon la revendication 1, dans lequel l'acheminement (220) du signal optique (42) comprend l'acheminement (220) du signal optique (42) à travers un interstice qui sépare spatialement la sonde optique (20) et la structure d'étalonnage (160).

3. Système de sondes (10) selon l'une quelconque des revendications 1 et 2, dans lequel le dispositif de commande (60) est en outre programmé pour tester optiquement (270) le dispositif testé (DUT) (150) et pour au moins l'un parmi :
(i) sélectionner une orientation relative initiale entre la sonde optique (20) et le DUT (150) sur la base, au moins en partie, de la représentation bidimensionnelle de l'intensité de signal sous la forme de la fonction de l'orientation relative entre la sonde optique (20) et la structure d'étalonnage (160) ; et
(ii) quantifier les performances optiques du DUT (150) sur la base, au moins en partie, du test optique et également de la représentation bidimensionnelle de l'intensité de signal sous la forme de la fonction de l'orientation relative entre la sonde optique (20) et la structure d'étalonnage (160).

4. Système de sondes (10) selon l'une quelconque des revendications 1 à 3, dans lequel la structure d'étalonnage (160) comporte une fibre optique de dispositif configurée pour recevoir le signal optique (42) en provenance de la sonde optique (20), et dans lequel la fibre optique de dispositif est en outre configurée pour acheminer une partie couplée du signal optique (42) vers le détecteur optique (50).

5. Système de sondes (10) selon l'une quelconque des revendications 1 à 4, dans lequel la structure d'étalonnage (160) comporte :
(i) un premier coupleur à réseau de diffraction (101) configuré pour recevoir une partie couplée du signal optique (42) en provenance de la sonde optique (20) ;
(ii) un guide d'ondes (154) configuré pour recevoir la partie couplée du signal optique (42) en provenance du premier coupleur à réseau de diffraction (101) ; et
(iii) un deuxième coupleur à réseau de diffraction (102) configuré pour recevoir la partie couplée du signal optique (42) en provenance du guide d'ondes (154) ;
facultativement, dans lequel le détecteur optique (50) est configuré pour recevoir la partie couplée du signal optique (42) en provenance du deuxième coupleur à réseau de diffraction (102) ; et
facultativement, dans lequel la sonde optique (20) est une première sonde optique (21), dans lequel le système de sondes (10) comprend en outre une deuxième sonde optique (22), dans lequel la deuxième sonde optique (22) est configurée pour recevoir la partie couplée du signal optique (42) en provenance du deuxième coupleur à réseau de diffraction (102) et pour acheminer la partie couplée du signal optique (42) vers le détecteur optique (50).

6. Système de sondes (10) selon l'une quelconque des revendications 1 à 5, dans lequel la structure d'étalonnage (160) comporte un guide d'ondes (154) configuré pour recevoir une partie couplée du signal optique (42) en provenance de la sonde optique (20), et facultativement,
dans lequel le guide d'ondes (154) réalise au moins l'une des conditions suivantes :
(i) est accessible à la sonde optique (20) par l'intermédiaire d'un bord du substrat (140) qui comporte la structure d'étalonnage (160) ;
(ii) est accessible à la sonde optique (20) par l'intermédiaire d'une tranchée qui s'étend dans le substrat (140) ; et
(iii) s'étend au moins sensiblement parallèlement à une surface supérieure du substrat (140) ;
facultativement, dans lequel le détecteur optique (50) est configuré pour recevoir la partie couplée du signal optique (42) en provenance du guide d'ondes (154) ;
et facultativement, dans lequel la sonde optique (20) est une première sonde optique (21), dans lequel le système de sondes (10) comporte en outre une deuxième sonde optique (22), dans lequel la deuxième sonde optique (22) est configurée pour recevoir la partie couplée du signal optique (42) en provenance du guide d'ondes (154) et pour acheminer la partie couplée du signal optique (42) vers le détecteur optique (50).

7. Système de sondes (10) selon l'une quelconque des revendications 1 à 6, dans lequel la structure d'étalonnage (160) comporte au moins l'une parmi :
(i) une structure d'étalonnage à arête de couteau ; et
(ii) une structure d'étalonnage à sténopé.

8. Système de sondes (10) selon l'une quelconque des revendications 1 à 7, dans lequel le dispositif de commande (60) est en outre programmé pour extraire une propriété optique qui décrit un couplage optique entre la sonde optique (20) et la structure d'étalonnage (160), facultativement, dans lequel la propriété optique comprend au moins l'une des suivantes :
(i) une distance focale de la sonde optique (20) ;
(ii) une distance de travail pour la sonde optique (20) ;
(iii) une ouverture numérique de la sonde optique (20) ;
(iv) un emplacement de taille de faisceau du signal optique (42) ;
(v) une dimension de taille de faisceau du signal optique (42) ;
(vi) un angle de divergence du signal optique (42) ;
(vii) une fluence du signal optique (42) ; et
(viii) un astigmatisme de la sonde optique (20).

9. Procédé (200) de caractérisation du couplage optique entre une sonde optique (20) d'un système de sondes (10) et une structure d'étalonnage (160), le procédé (200) comprenant :
le positionnement (210) de la sonde optique (20) et de la structure d'étalonnage (160) à proximité l'une de l'autre ;
l'acheminement (220) d'un signal optique (42) de la sonde optique (20) à la structure d'étalonnage (160) ;
pendant l'acheminement (220), la détection (230) d'une intensité de signal du signal optique (42) ; et
pendant l'acheminement (220) et également pendant la détection (230), la modification (240) d'une orientation relative entre la sonde optique (20) et la structure d'étalonnage (160) pour générer une représentation bidimensionnelle de l'intensité de signal sous la forme d'une fonction de l'orientation relative entre la sonde optique (20) et la structure d'étalonnage (160), dans lequel la modification (240) comprend un balayage de la sonde optique (20) et de la structure d'étalonnage (160) l'une par rapport à l'autre en deux dimensions et à l'intérieur d'un premier plan de balayage pour générer une corrélation entre l'intensité de signal et la position à l'intérieur du premier plan de balayage,
**caractérisé en ce que** la modification (240) comprend en outre :
(i) le déplacement de la sonde optique (20) et de la structure d'étalonnage (160) l'une par rapport à l'autre dans une troisième dimension qui est perpendiculaire au premier plan de balayage ; et
(ii) la répétition du balayage pour générer la corrélation entre l'intensité de signal et la position à l'intérieur d'un deuxième plan de balayage espacé du premier plan de balayage.

10. Procédé (200) selon la revendication 9, dans lequel le procédé (200) comprend l'exécution répétée du déplacement et de la répétition du balayage pour générer la corrélation entre l'intensité de signal et la position à l'intérieur d'une pluralité de plans de balayage espacés les uns des autres.

11. Procédé (200) selon l'une quelconque des revendications 9 à 10, dans lequel le procédé (200) comprend en outre le test optique (270) d'un dispositif testé (DUT) (150), et dans lequel le test optique (270) comprend au moins l'une parmi :
(i) la sélection d'une orientation relative initiale entre la sonde optique (20) et le DUT (150) sur la base, au moins en partie, de la représentation bidimensionnelle de l'intensité de signal sous la forme de la fonction de l'orientation relative entre la sonde optique (20) et la structure d'étalonnage (160) ; et
(ii) la quantification des performances optiques du DUT (150) sur la base, au moins en partie, du test optique (270) et également de la représentation bidimensionnelle de l'intensité de signal sous la forme de la fonction de l'orientation relative entre la sonde optique (20) et la structure d'étalonnage (160).

12. Procédé (200) selon l'une quelconque des revendications 9 à 11, dans lequel le procédé (200) comprend en outre l'extraction (260) d'une propriété optique qui décrit un couplage optique entre la sonde optique (20) et la structure d'étalonnage (160), dans lequel la propriété optique comprend au moins l'une parmi :
(i) une distance focale de la sonde optique (20) ;
(ii) une distance de travail pour la sonde optique (20) ;
(iii) une ouverture numérique de la sonde optique (20) ;
(iv) un emplacement de taille de faisceau du signal optique (42) ;
(v) une dimension de taille de faisceau du signal optique (42) ;
(vi) un angle de divergence du signal optique (42) ;
(vii) une fluence du signal optique (42) ; et
(viii) un astigmatisme de la sonde optique (20).

13. Support de stockage non transitoire lisible par ordinateur **caractérisé en ce qu'**il comprend des instructions lisibles par ordinateur qui, lorsqu'elles sont exécutées, amènent un système de sondes (10) à mettre en œuvre le procédé (200) selon l'une quelconque des revendications 9 à 12.
